# EUROPEAN PATENT SPECIFICATION

(11) **EP 4 334 227 B1**
(45) Date of publication and mention of the grant of the patent: **22.07.2026**
(21) Application number: 22799280.7
(22) Date of filing: 18.04.2022
(51) Int. Cl.: B65H 20/14, C23C 14/56, C23C 14/24, B65H 27/00, B65H 23/24, B65H 23/26, B65H 20/02, C23C 14/54, C23C 16/458, C23C 16/46, C23C 16/54

(54) **ROLLER FOR TRANSPORTING A FLEXIBLE SUBSTRATE, VACUUM PROCESSING APPARATUS, AND METHODS THEREFOR**
WALZE ZUM TRANSPORT EINES FLEXIBLEN SUBSTRATS, VAKUUMVERARBEITUNGSVORRICHTUNG UND VERFAHREN DAFÜR
ROULEAU POUR TRANSPORTER UN SUBSTRAT FLEXIBLE, APPAREIL DE TRAITEMENT SOUS VIDE ET PROCÉDÉS ASSOCIÉS

(30) Priority: 04.05.2021 US 202117307195
(43) Date of publication of application: 13.03.2024
(73) Proprietor: Elevated Materials Germany GmbH, 63755 Alzenau (DE)
(72) Inventor: DEPPISCH, Thomas, 63743 Aschaffenburg (DE); BANGERT, Stefan, 36396 Steinau (DE); ARMSTRONG, Claire, 51643 Gummersbach (DE); SCHNAPPENBERGER, Frank, 63867 Johannesberg (DE)
(74) Representative: Zimmermann & Partner Patentanwälte mbB
(86) International application number: PCT/US2022/025188
(87) International publication number: WO 2022/235420

(56) References cited:
- WO-A1-2017/207053
- DE-A1- 19 818 180
- JP-A- 2019 203 171
- JP-A- S 597 655
- KR-A- 20100 091 984
- US-A- 4 207 998
- US-A1- 2012 006 520
- US-A1- 2020 308 693

## Description

### TECHNICAL FIELD

Embodiments of the present disclosure relate to rollers for transporting a flexible substrate. Further, embodiments of the disclosure relate to apparatuses and methods for flexible substrate processing, particularly coating of flexible substrates with thin layers, using a roll-to-roll process. In particular, embodiments of the disclosure relate to rollers employed for transportation of flexible substrates in apparatuses and methods for coating the flexible substrate with a stack of layers, e.g. for thin-film solar cell production, thin-film battery production, or flexible display productior A prior art solution has been disclosed in JP 2019 203 171 A.

### BACKGROUND

Processing of flexible substrates, such as plastic films or foils, is in high demand in the packaging industry, semiconductor industries and other industries. Processing may consist of coating a flexible substrate with a material, such as a metal, a semiconductor and a dielectric material, etching and other processing actions conducted on a substrate for the respective applications. Systems performing this task typically include a coating drum, e.g. a cylindrical roller, coupled to a processing system with a roller assembly for transporting the substrate, and on which at least a portion of the substrate is coated.

For example, a coating process such as a CVD process, a PVD process or an evaporation process can be utilized for depositing thin layers onto flexible substrates. Roll-to-roll deposition apparatuses are understood in that a flexible substrate of a considerable length, such as one kilometer or more, is uncoiled from a supply spool, coated with a stack of thin layers, and recoiled again on a wind-up spool. In particular, in the manufacture of thin film batteries, e.g. lithium batteries, the display industry and the photovoltaic (PV) industry, roll-to-roll deposition systems are of high interest. For example, the increasing demand for flexible touch panel elements, flexible displays, and flexible PV modules results in an increasing demand for depositing suitable layers in roll-to-roll -coaters.

For achieving high quality coatings on flexible substrates, various challenges with respect to flexible substrate transportation have to be mastered. For example, providing an appropriate substrate tension as well as a good substrate-roller contact and substrate cooling during the processing of the moving flexible substrate under vacuum conditions remain challenging.

Accordingly, there is a continuous demand for improved substrate transportation rollers, improved roll-to-roll processing apparatuses and methods therefor.

### SUMMARY

In light of the above, a roller for transporting a flexible substrate, a vacuum processing apparatus for processing a flexible substrate, a method of manufacturing a roller for guiding a flexible substrate, a method of processing a flexible substrate, and a method of manufacturing a coated flexible substrate according to the independent claims are provided. Further aspects, advantages, and features are apparent from the dependent claims, the description, and the accompanying drawings.

According to an aspect of the present disclosure, a roller for transporting a flexible substrate is provided. The roller includes a main body having a plurality of gas supply slits provided in an outer surface of the main body. The plurality of gas supply slits extends in a direction of a central rotation axis of the roller. Further, the roller includes a sleeve provided circumferentially around and in contact with the main body. The sleeve has a plurality of gas outlets provided above the plurality of gas supply slits. Further, the sleeve includes a metal layer embedded within isolating material.

According to another aspect of the present disclosure, a roller for transporting a flexible substrate is provided. The roller includes a main body having a plurality of gas supply slits provided in an outer surface of the main body. The plurality of gas supply slits extends in a direction of a central rotation axis of the roller. Additionally, the roller includes a sleeve provided circumferentially around and in contact with the main body. The sleeve includes a plurality of insets of isolating material with a plurality of gas outlets. The plurality of gas outlets is provided above the plurality of gas supply slits.

According to a further aspect of the present disclosure, a vacuum processing apparatus for processing a flexible substrate is provided. The vacuum processing apparatus includes a processing chamber including a plurality of processing units having at least one deposition unit. Further, the vacuum processing apparatus includes a roller according to any embodiments described herein for guiding the flexible substrate past the plurality of processing units. In particular, the roller is connected to an electrical potential application device.

According to another aspect of the present disclosure, a method of manufacturing a roller for guiding a flexible substrate is provided. The method includes producing a sleeve having a plurality of gas outlets by using laser drilling. The sleeve includes at least one of a metal layer embedded within isolating material and a plurality of insets of isolating material. Further, the method includes providing the sleeve circumferentially around and in contact with a main body of the roller having a plurality of gas supply slits provided in an outer surface of the main body such that the plurality of gas outlets is arranged above the plurality of gas supply slits.

According to a further aspect of the present disclosure, a method of processing a flexible substrate is provided. The method includes guiding the flexible substrate past one or more processing units by using a roller for transporting the flexible substrate according to any embodiments described herein. Further, the method includes controlling a temperature of the flexible substrate by providing gas to the flexible substrate through the plurality of gas outlets of the roller.

According to another aspect of the present disclosure, a method of manufacturing a coated flexible substrate is provided. The method includes using at least one of a roller according to any embodiments described herein, a vacuum processing apparatus according to any embodiments described herein, and a method of processing a flexible substrate according to any embodiments described herein.

Embodiments are also directed at apparatuses for carrying out the disclosed methods and include apparatus parts for performing each described method aspect. These method aspects may be performed by way of hardware components, a computer programmed by appropriate software, by any combination of the two or in any other manner. Furthermore, embodiments according to the disclosure are also directed at methods for operating the described apparatus. The methods for operating the described apparatus include method aspects for carrying out every function of the apparatus.

### BRIEF DESCRIPTION OF THE DRAWINGS

So that the manner in which the above recited features of the present disclosure can be understood in detail, a more particular description of the disclosure, briefly summarized above, may be had by reference to embodiments. The accompanying drawings relate to embodiments of the disclosure and are described in the following:
FIG. 1A shows a schematic longitudinal sectional view of a roller according to embodiments described herein;
FIG. 1B shows a cross-sectional view along line A-A indicated in Fig. 1A;
FIG. 1C shows an enlarged portion of FIG. 1B;
FIGS. 2 to 4 show schematic cross-sectional views of a portion of a roller according to further embodiments described herein;
FIG. 5 shows a schematic view of a vacuum processing apparatus according to embodiments described herein;
FIGS. 6A and 6B show block diagrams for illustrating embodiments of a method of manufacturing a roller for guiding a flexible substrate according to the present disclosure; and
FIGS. 7A and 7B show block diagrams for illustrating embodiments of a method of processing a flexible substrate according to embodiments described herein.

### DETAILED DESCRIPTION OF EMBODIMENTS

Reference will now be made in detail to the various embodiments of the disclosure, one or more examples of which are illustrated in the figures. Within the following description of the drawings, the same reference numbers refer to same components. Only the differences with respect to individual embodiments are described. Each example is provided by way of explanation of the disclosure and is not meant as a limitation of the disclosure. Further, features illustrated or described as part of one embodiment can be used on or in conjunction with other embodiments to yield yet a further embodiment. It is intended that the description includes such modifications and variations.

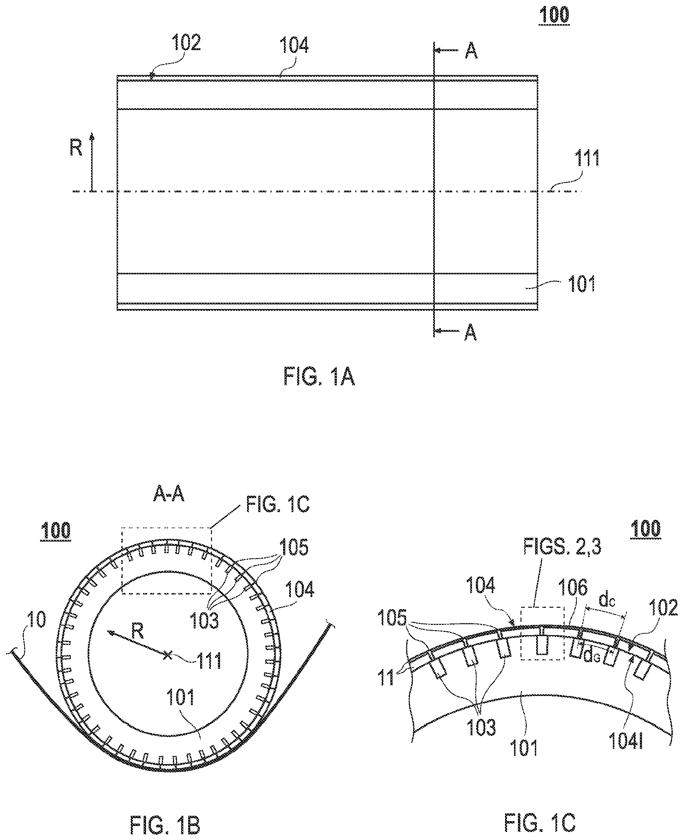

With exemplary reference to FIGS. 1A to 1C, a roller 100 for transporting a flexible substrate 10 according to the present disclosure is described. According to embodiments, which can be combined with any other embodiments described herein, the roller 100 includes a main body 101 having a plurality of gas supply slits 103. The plurality of gas supply slits 103 are provided in an outer surface 102 of the main body 101. Further, the plurality of gas supply slits 103 extend in a direction of a central rotation axis 111 of the roller 100. Additionally, the roller 100 includes a sleeve 104 provided circumferentially around and in contact with the main body 101. The sleeve 104 includes a plurality of gas outlets 105 being provided above the plurality of gas supply slits 103. In particular, as exemplarily shown in FIGS. 1B and 1C, the plurality of gas outlets 105 is directly provided above the plurality of gas supply slits 103. More specifically, typically an inner surface 104I of the sleeve 104 with the plurality of gas outlets 105 is in contact with the outer surface 102 of the main body 101 having the plurality of gas supply slits 103. Accordingly, each gas outlet of the plurality of gas outlets 105 is provided above a respective gas supply slit of the plurality of gas supply slits 103.

Typically, the plurality of gas outlets 105 extends in a radial direction R. Further, the sleeve includes comprising a metal layer 106 embedded within isolating material 11.

Accordingly, compared to the prior art, beneficially an improved roller for transporting a flexible substrate is provided. In particular, embodiments of the roller described herein provide for the possibility to employ electrostatic interaction between a roller and a flexible substrate in order to increase the contact pressure, particularly in combination with a gas cooling of the flexible substrate. Further, due to the possibility of increasing the contact pressure between the roller and the flexible substrate, a higher gas pressure for substrate cooling can be used resulting in an improved cooling efficiency. Moreover, the particular configuration of the embodiments of the roller as described herein, e.g. providing an outer surface of the roller with an isolating material, means that detrimental effects such as current leakages or arcing caused by applying an electrical potential to the roller can be avoided.

Before various further embodiments of the present disclosure are described in more detail, some aspects with respect to some terms used herein are explained.

In the present disclosure, a "roller" can be understood as a drum or a roller having a substrate support surface for contacting the flexible substrate. The expression "substrate support surface for contacting the flexible substrate" can be understood in that the outer surface of the roller, e.g. the outer surface of the sleeve as described herein, is configured for contacting the flexible substrate during the guiding or transportation of the flexible substrate. Typically, the support surface is a curved outer surface, particularly a cylindrical outer surface, of the roller. Accordingly, typically the roller is rotatable about a rotation axis and includes a substrate guiding region. Typically, the substrate guiding region is a curved substrate support surface, e.g. a cylindrically symmetric surface, of the roller. The curved substrate support surface of the roller may be adapted to be (at least partly) in contact with the flexible substrate during the guiding of the flexible substrate. The substrate guiding region may be defined as an angular range of the roller in which the substrate is in contact with the curved substrate support surface during the guiding of the substrate, and may correspond to the enlacement angle of the roller. For instance, the enlacement angle of the roller may be 120° or more, particularly 180° or more, or even 270° or more. According to some embodiments, which can be combined with other embodiments described herein, the roller 100 is cylindrical and has a length L of 0.5 m ≤ L ≤ 8.5 m. Further, the roller 100 may have a diameter D of 1.0 m ≤ D ≤ 3.0 m. Accordingly, beneficially the roller is configured for guiding and transporting flexible substrates having a large width.

In the present disclosure, a "flexible substrate" can be understood as a bendable substrate. For instance, the "flexible substrate" can be a "foil" or a "web". In the present disclosure the term "flexible substrate" and the term "substrate" may be synonymously used. For example, the flexible substrate as described herein may be made of or include materials like PET, HC-PET, PE, PI, PU, TaC, OPP, BOOP, CPP, one or more metals (e.g. copper), paper, combinations thereof, and already coated substrates like Hard Coated PET (e.g HC-PET, HC-TaC) and the like. In some embodiments, the flexible substrate is a COP substrate provided with an index matched (IM) layer on both sides thereof. For example, the substrate thickness can be 1 µm or more and 1 mm or less, particularly 500 µm or less, or even 200 µm or less. The substrate width W_{S} can be 0.3 m ≤ W ≤ 8 m. The substrate may be a transparent or non-transparent substrate.

In the present disclosure, a "main body" of the roller can be understood as a cylindrical body, particularly a cylindrical shell body of solid material. Typically, the main body is made of a material having a high thermal conductivity λ, particularly λ ≥ 50 W/(m·K), more particularly λ ≥ 100 W/(m·K). For instance, the main body can be made of a material including copper such as copper alloys. In particular, the main body can be made of copper. It is to be understood that alternatively the main body may be made of any other suitable material having high thermal conductivity λ.

In the present disclosure, a "gas supply slit" can be understood as a slit configured for supplying gas to a plurality of gas outlets as described herein. In particular, typically a "gas supply slit" as described herein is provided in an outer surface of the main body and extends parallel to a central rotation axis of the roller. Typically, the central rotation axis of the roller corresponds to the central rotation axis of the main body. Moreover, typically a "gas supply slit" as described herein is connected to a gas supply. According to embodiments which can be combined with other embodiments described herein, the distance d_{G} between gas supply slits in the circumferential direction can be selected from a range between a lower limit d_{GL} and an upper limit d_{GU}, i.e d_{GL} ≤ d_{G} ≤ d_{GU}. The distance d_{G} is exemplarily indicated in FIG. 1E. The lower limit d_{GL} can be d_{GL} = 4 mm, particularly d_{GL} = 6 mm, more particularly d_{GL} = 8 mm. The upper limit d_{GU} can be d_{GU} = 10 mm, particularly d_{GU} = 12 mm, more particularly d_{GU} = 15 mm. For instance, the distance d_{G} can be 10 mm.

In the present disclosure, a "sleeve" can be understood as a sleeve being in contact with an outer surface of a main body as described herein. Accordingly, the sleeve can be a shell provided circumferentially around and in contact with the main body. Typically, during transportation of the flexible substrate, the sleeve is at least partially in contact with the flexible substrate. In particular, the sleeve can provide the substrate support surface as described herein. Typically, the sleeve is made of a metal sheet. The sleeve can have a thickness T selected from a range between a lower limit T_{L} and an upper limit T_{U}, i.e. T_{L} ≤ T ≤ T_{U}. The lower limit T_{L} can be T_{L} = 0.5 mm, particularly T_{L} = 1.0 mm, more particularly T_{L} = 1.5 mm. The upper limit T_{U} can be T_{U} = 2.0 mm, particularly T_{U} = 2.5 mm, more particularly T_{U} = 3.0 mm.

In the present disclosure, a "gas outlet" can be understood as an outlet configured for providing gas to a flexible substrate during substrate transportation by the roller as described herein. Accordingly, a gas outlet as described herein can be understood as a gas discharge hole. The outlet diameter Dₒᵤₜ of a gas outlet according to the present disclosure can be selected from a range between a lower limit D_{L} and an upper limit D_{U}, i.e. D_{L} ≤ Dₒᵤₜ ≤ D_{U}. The lower limit D_{L} can be D_{L} = 30 µm, particularly D_{L} = 40 µm, more particularly D_{L} = 60 µm. The upper limit D_{U} can be D_{U} = 150 µm, particularly D_{U} = 100 µm, more particularly D_{U} = 80 µm. Typically, a gas outlet as described herein is created by using a laser drilling method. Laser drilling may also be referred to as laser firing. Typically, a "gas outlet" as described herein has a cylindrical inner surface having an inner diameter corresponding to the outlet diameter Dₒᵤₜ of the gas outlet as described herein. In other words, a "gas outlet" as described herein can be understood as a cylindrical outlet having a constant outlet diameter Dₒᵤₜ along the outlet axis, typically extending in the radial direction.

According to embodiments which can be combined with other embodiments described herein, the distance d_{C} between neighbouring gas outlets in the circumferential direction can be selected from a range between a lower limit d_{CL} and an upper limit d_{CU}, i.e d_{CL} ≤ d_{C} ≤ d_{CU}. The lower limit d_{CL} can be d_{CL} = 4 mm, particularly d_{CL} = 6 mm, more particularly d_{CL} = 8 mm. The upper limit d_{CU} can be d_{CU} = 10 mm, particularly d_{CU} = 12 mm, more particularly d_{CU} = 15 mm. For instance, the distance d_{C} can be 10 mm. The distance d_{C} between neighbouring gas outlets 105 in the circumferential direction is exemplarily indicated in FIG. 1C. Typically, the distance d_{C} is the distance between the central axis of the neighbouring gas outlets 105, as shown in FIG. 1C. Accordingly, typically the distance d_{G} between neighbouring gas supply slits 103 is the distance between the central axis of the neighbouring gas supply slits 103. In particular, as exemplarily shown in FIG. 1C, the distance d_{G} may substantially correspond to the distance d_{C}, i.e. d_{G} = d_{C}. The term "substantially correspond" is to be understood in that the effect due to the curvature of the roller on the difference between d_{G} and d_{C} can be neglected since the diameter D of the roller is much larger than the distance d_{G} between neighbouring gas supply slits as well as the distance d_{C} between neighbouring gas outlets in the circumferential direction, i.e. D >> d_{C} and D >> d_{G}. Accordingly, to be exact, the angle between the central axes of the neighbouring gas outlets 105 can be identical to the angle between the central axes of the neighbouring gas supply slits 103. As exemplarily shown in FIG. 1B, typically the number of gas outlets 105 in the circumferential direction corresponds to the number of gas supply slits 103. Alternatively, the number of gas outlets in the circumferential direction may be any integer multiple of the number of gas supply slits.

According to embodiments which can be combined with other embodiments described herein, the distance d_{A} between neighbouring gas outlets in the axial direction can be selected from a range between a lower limit d_{AL} and an upper limit d_{AU}, i.e d_{AL} ≤ d_{A} ≤ d_{AU}. The lower limit d_{AL} can be d_{AL} = 4 mm, particularly d_{AL} = 6 mm, more particularly d_{AL} = 8 mm. The upper limit d_{AL} can be d_{AL} = 10 mm, particularly d_{AL} = 12 mm, more particularly d_{AL} = 15 mm. For instance, the distance d_{A} can be 10 mm.

According to embodiments which can be combined with other embodiments described herein, the distance d_{C} between neighbouring gas outlets in the circumferential direction corresponds to the distance d_{A} between neighbouring gas outlets in the axial direction, i.e. d_{C} = d_{A}. In other words, the plurality of gas outlets as described herein may be regularly distributed in the sleeve.

In the present disclosure, a "metal layer embedded within isolating material" can be understood as a layer of metal surrounded by an isolating material. For instance, the metal layer can have a thickness T_{M} selected from a range between a lower limit T_{ML} and an upper limit T_{MU}, i.e. T_{ML}≤ T_{M} ≤ T_{MU}. The lower limit T_{ML} can be T_{ML} = 10 µm, particularly T_{ML} = 20 µm, more particularly T_{ML} = 30 µm. The upper limit T_{MU} can be T_{MU} = 200 µm, particularly T_{MU} = 150 µm, more particularly T_{MU} = 100 µm.

It is to be understood that the metal layer embedded within isolating material as described herein may function as an E-chuck. Typically, an E-chuck is understood as a device configured for providing an electrostatic charge for holding a substrate by electrostatic force. Accordingly, the E-chuck is configured for providing an attraction force for holding the flexible substrate in contact with the curved surface of the roller. Accordingly, a constant and homogenous contact force between the flexible substrate and the roller may be further improved.

In the present disclosure, an "isolating material" can be understood as an electrically isolating material. Accordingly, an "isolating material" may be understood as an electrically non-conductive material, e.g. having very low electrical conductivity or negligible electrical conductivity. For instance, the isolating material may be a ceramic material or a polymeric material.

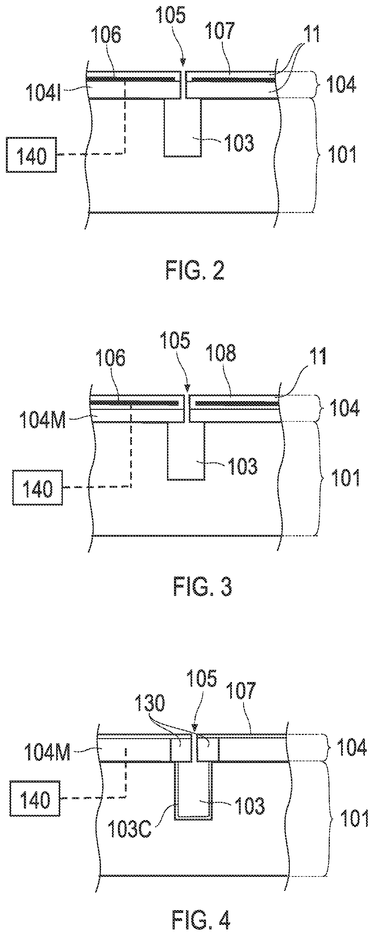

With exemplary reference to FIG. 2, according to embodiments which can be combined with any other embodiments described herein, the sleeve 104 includes an isolating top layer 107 and an inner isolating sleeve 104I. As shown in FIG. 2, the metal layer 106 can be provided between the isolating top layer 107 and the inner isolating sleeve 104I. In particular, the metal layer 106 may be provided under the isolating top layer 107. More specifically, the metal layer 106 can be provided directly under the isolating top layer. Accordingly, the metal layer 106 may be in contact with the isolating top layer. Further, the metal layer 106 can be provided on top of the inner isolating sleeve 104I. In particular, the metal layer 106 can be provided directly on top of the inner isolating sleeve 104I. Accordingly, the metal layer 106 may be in contact with the inner isolating sleeve 104I.

As exemplarily shown in FIG. 2, according to embodiments which can be combined with any other embodiments described herein, the plurality of gas outlets 105 extends through the isolating top layer 107 and the inner isolating sleeve 104I. Accordingly, the inner walls of the gas outlets are provided with isolating material 11, i.e. the isolating material of the isolating top layer 107 and the isolating material of the inner isolating sleeve 104I. In other words, the inner walls of the gas outlets may consist of isolating material. It is to be understood that the isolating top layer 107 and the inner isolating sleeve 104I consist of isolating material 11.

With exemplary reference to FIG. 3, according to embodiments which can be combined with any other embodiments described herein, the sleeve 104 includes an outer isolating layer 108 provided on an inner metal sleeve 104M. The metal layer 106 is embedded within the outer isolating layer 108. It is to be understood that the outer isolating layer 108 consists of isolating material 11. As exemplarily shown in FIG. 3, the plurality of gas outlets 105 extend through the outer isolating layer 108 and the inner metal sleeve 104M. Accordingly, the inner walls of the gas outlets are provided with isolating material of the outer isolating layer 108 and material of the inner metal sleeve 104M.

According to embodiments which can be combined with any other embodiments described herein, the metal layer 106 is connected to an electrical potential application device 140, as schematically indicated in FIGS. 2 and 3.

In the present disclosure, an "electrical potential application device" can be understood as a device being configured to apply an electrical potential to the roller, particularly to the metal layer of the roller. In particular, the electrical potential application device as described herein can be configured to provide a middle frequency (MF) electrical potential. For instance, the middle frequency (MF) electrical potential can be from 1 kHz to 100 kHz. Typically, the electrical potential application device is connected to the roller via a physical contact, e.g an electrical contact. Accordingly, an electrical contact can be provided between the electrical potential application device and the roller. For instance, the electrical contact can be an electrical sliding contact or an electrical brush contact. According to another example, the electrical contact can be a plug contact. Accordingly, the electrical potential application device can be understood as a charging device configured for providing an electrical charge to the roller, particularly the metal layer embedded in isolating material. It is to be understood that typically electrical connection lines to the embedded metal layer are provided.

According to embodiments which can be combined with any other embodiments described herein, the electrical potential application device is configured for applying an electrical potential having a middle frequency (MF), particularly a frequency of 1 kHz to 100 kHz. In other words, the electrical potential provided from the electrical potential application device can be an electrical potential having a frequency of 1 kHz to 100 kHz. In particular, a middle frequency electric potential can be understood as an electrical potential with an alternating polarity at a frequency selected from the range of 1 kHz to 100 kHz. It has been found that applying a MF electrical potential to the coating drum has the advantage that a charge up of the substrate, particularly of the layer deposited on the substrate, can substantially be avoided or even eliminated. Accordingly, layers with higher quality (e.g. higher uniformity, less defects, etc.) can be deposited on the substrate.

With exemplary reference to FIG. 4, an alternative roller configuration is described which addresses the same problem as the embodiments of the roller as described with reference to FIGS. 1A, 1B, 2 and 3. In particular, the alternative roller configuration shown in FIG. 4 also beneficially provides for the possibility of increasing the contact pressure between the roller and the flexible substrate by using electrostatic interaction while at the same time detrimental effects such as current leakages or arcing caused by applying an electrical potential to the roller can be avoided.

As schematically shown in FIG. 4, according to embodiments which can be combined with any other embodiments described herein, the roller 100 includes a main body 101 having a plurality of gas supply slits 103 provided in an outer surface 102 of the main body 101. The plurality of gas supply slits 103 extends in a direction of the central rotation axis 111 of the roller 100. Further, the roller 100 includes a sleeve 104 provided circumferentially around and in contact with the main body 101. The sleeve 104 includes a plurality of insets 130 and the plurality of insets 130 includes an isolating material. Further, each of the plurality of insets 130 includes gas outlet 105. Accordingly, the plurality of gas outlets 105 is provided in the plurality of insets 130. The plurality of gas outlets 105 is provided above the plurality of gas supply slits 103.

According to embodiments which can be combined with any other embodiments described herein, the surfaces of the gas supply slits 103 can be coated with isolating material. In other words, the gas supply slits 103 may include anisolating coating 103C, as exemplarily shown in FIG. 4. Further, the sleeve 104 may include an isolating top layer 107 and an inner metal sleeve 104M. In particular, the isolating top layer 107 may also cover the outer top surfaces of the plurality of insets 130. Further, as schematically indicated in FIG. 4, the inner metal sleeve 104M may be connected to an electrical potential application device 140 as described herein. Alternatively, the electrical potential application device 140 may be connected to the main body 101.

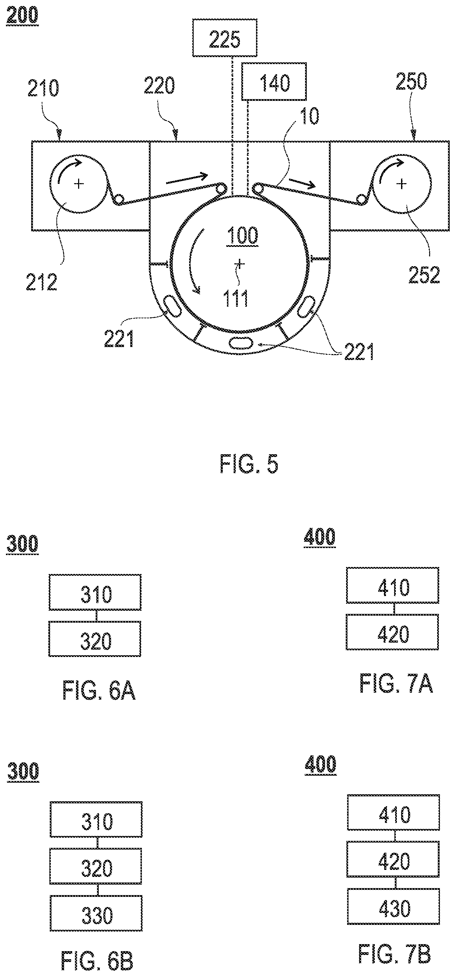

With exemplary reference to FIG. 5, a vacuum processing apparatus 200 according to the present disclosure is described. According to embodiments, which can be combined with any other embodiments described herein, the vacuum processing apparatus 200 includes a processing chamber 220 including a plurality of processing units 221. The plurality of processing units 221 includes at least one deposition unit. Further, the vacuum processing apparatus 200 includes a roller 100 according to any embodiments described herein for guiding the flexible substrate past the plurality of processing units 221. As schematically shown in FIG. 4, the roller 100 can be connected to an electrical potential application device 140. Further, the roller 100 can be connected to a gas supply 225. Typically, the gas supply 225 is configured for supplying a cooling gas to the roller 100, such that the cooling gas can be provided to the flexible substrate through the plurality of gas outlets 105 as described herein.

As exemplarily shown in FIG. 5, typically the vacuum processing apparatus 200 is a roll-to-roll processing system. The roller 100 according to any embodiments described herein can be a processing drum or coating drum of the vacuum processing apparatus. According to embodiments, which can be combined with any other embodiments described herein, the vacuum processing apparatus 200 includes a first spool chamber 210 housing a storage spool 212 for providing the flexible substrate 10. Additionally, the vacuum processing apparatus 200 includes the processing chamber 220 arranged downstream from the first spool chamber 210. Typically, the processing chamber 220 is a vacuum chamber and includes the plurality of processing units 221. The plurality of processing units 221 includes at least one deposition unit. Accordingly, in the present disclosure, a "processing chamber" can be understood as a chamber having at least one deposition unit for depositing material on a substrate. Accordingly, the processing chamber may also be referred to as a deposition chamber. The term "vacuum", as used herein, can be understood in the sense of a technical vacuum having a vacuum pressure of less than, for example, 10 mbar. Typically, the pressure in a vacuum chamber as described herein may be between 10⁻⁵ mbar and about 10⁻⁸ mbar, more typically between 10⁻⁵ mbar and 10⁻⁷ mbar, and even more typically between about 10⁻⁶ mbar and about 10⁻⁷ mbar.

As exemplarily shown in FIG. 5, the plurality of processing units may be arranged in a circumferential direction around the roller 100. As the roller 100 rotates, the flexible substrate 10 is guided past the processing units which face toward the curved substrate support surface of the roller, so that the surface of the flexible substrate can be processed while being moved past the processing units at a predetermined speed. For example, the plurality of processing units may include one or more units selected from the group consisting of: a deposition unit, an etching unit, and a heating unit. A deposition unit of the vacuum processing apparatus as described herein can be a sputter deposition unit, e.g. an AC (alternating current) sputter source or a DC (direct current) sputter source, a RF (radio frequency) sputter source, aMF (middle frequency) sputter source, a pulsed sputter source, a pulsed DC sputter source, a magnetron sputter source, a reactive sputter source, a CVD deposition unit, a PECVD deposition unit, a PVD deposition unit or another suitable deposition unit. It is to be understood that typically a deposition unit as described herein is adapted for depositing a thin film on a flexible substrate, e.g., to form a flexible display device, a touch-screen device component, or other electronic or optical devices. A deposition unit as described herein can be configured for depositing at least one material selected from the group of conductive materials, semi-conductive materials, dielectric materials, or isolating materials.

Additionally, as exemplarily shown in FIG. 4, the vacuum processing apparatus 200 may include a second spool chamber 250 arranged downstream from the processing chamber 220. The second spool chamber 250 houses a wind-up spool 252 for winding the flexible substrate 10 thereon after processing.

With exemplary reference to the block diagram shown in FIG. 6A, a method 300 of manufacturing a roller for guiding a flexible substrate according the present disclosure is described. According to embodiments, which can be combined with any other embodiments described herein, the method 300 includes producing (represented by block 310 in FIG. 6A) a sleeve 104 having a plurality of gas outlets 105 by using laser drilling. The sleeve 104 includes a metal layer 106 embedded within isolating material and/or a plurality of insets 130 of isolating material. Further, the method includes providing (represented by block 320 in FIG. 6A) the sleeve 104 circumferentially around and in contact with a main body 101 of the roller 100 having a plurality of gas supply slits 103 provided in an outer surface of the main body 101, such that the plurality of gas outlets 105 is arranged above the plurality of gas supply slits 103. It is to be understood that the sleeve 104 can have any configuration as described herein, e.g. as described with reference to FIGS. 1A, 1B, 2, 3 and 4.

According to embodiments, which can be combined with any other embodiments described herein, the method 300 further includes providing (represented by block 330 in FIG. 6B) surfaces of the gas supply slits 103 with a coating of isolating material.

With exemplary reference to the block diagram shown in FIG. 7A, a method 400 of processing a flexible substrate according to the present disclosure is described. According to embodiments, which can be combined with any other embodiments described herein, the method includes guiding (represented by block 410 in FIG. 7A) the flexible substrate 10 past one or more processing units 221 by using a roller 100 for transporting the flexible substrate 10 according to any embodiments described herein. Further, the method includes controlling (represented by block 420 in FIG. 7A) a temperature of the flexible substrate 10 by providing gas to the flexible substrate through the plurality of gas outlets 105 of the roller 100.

According to embodiments, which can be combined with any other embodiments described herein, the method 400 further includes applying (represented by block 430 in FIG. 7B) an electrical potential to the metal layer 106 embedded within isolating material of the sleeve 104. Additionally or alternatively, an electrical potential may be applied to the main body 101 and or the inner metal sleeve 104M as described herein.

In view of the embodiments described herein, it is to be understood that, according to an aspect of the present disclosure, a method of manufacturing a coated flexible substrate can be provided. The method includes using at least one of a roller 100 according to any embodiments described herein, a vacuum processing apparatus 200 according to any embodiments described herein, and a method 400 of processing a flexible substrate according to any embodiments described herein.

In view of the above, it is to be understood that, compared to the state of the art, embodiments as described herein provide for improved flexible substrate transportation and substrate cooling, such that beneficially thinner and wider flexible substrates can be processed with improved processing results.

## Claims

1. A roller (100) for transporting a flexible substrate (10), comprising:
a main body (101) having a plurality of gas supply slits (103) provided in an outer surface (102) of the main body (101), the plurality of gas supply slits (103) extending in a direction of a central rotation axis (111) of the roller (100); and
a sleeve (104) provided circumferentially around and in contact with the main body (101), the sleeve (104) having a plurality of gas outlets (105) being provided above the plurality of gas supply slits (103), the roller being **characterized by** the sleeve (104) comprising a metal layer (106) embedded within isolating material.

2. The roller (100) of claim 1, the sleeve (104) comprising an isolating top layer (107) and an inner isolating sleeve (1041), and the metal layer (106) being provided between the isolating top layer (107) and the inner isolating sleeve (1041).

3. The roller (100) of claim 2, the metal layer (106) being provided under the isolating top layer (107), particularly directly under the isolating top layer (107).

4. The roller (100) of claim 2 or 3, the metal layer (106) being provided on top of the inner isolating sleeve (1041), particularly directly on top of the inner isolating sleeve (1041).

5. The roller (100) of any of claims 2 to 4, wherein the plurality of gas outlets (105) extend through the isolating top layer (107) and the inner isolating sleeve (104I), such that inner walls of the gas outlets of isolating material are provided.

6. The roller (100) of claim 1, the sleeve (104) comprising an outer isolating layer (108) provided on an inner metal sleeve (104M), the metal layer (106) being embedded within the outer isolating layer (108), particularly wherein the plurality of gas outlets (105) extend through the outer isolating layer (108) and the inner metal sleeve (104M), such that inner walls of the gas outlets of material of the outer isolating layer (108) and material of the inner metal sleeve (104M) are provided.

7. The roller of any of claims 1 to 6, wherein the metal layer (106) is connected to an electrical potential application device (140).

8. A roller (100) for transporting a flexible substrate (10), comprising:
a main body (101) having a plurality of gas supply slits (103) provided in an outer surface (102) of the main body (101), the plurality of gas supply slits (103) extending in a direction of a central rotation axis (111) of the roller (100); and
a sleeve (104) provided circumferentially around and in contact with the main body (101), the roller being **characterized by** of the sleeve (104) having a plurality of insets (130) of isolating material with a plurality of gas outlets (105) being provided above the plurality of gas supply slits (103).

9. The roller (100) of claim 8, wherein surfaces of the gas supply slits (103) are coated with isolating material.

10. The roller (100) of claim 8 or 9, wherein the sleeve (104) comprises an isolating top layer (107) and an inner metal sleeve (104M).

11. The roller (100) of any of claims 1 to 10, wherein the number of gas outlets (105) in the circumferential direction corresponds to the number of gas supply slits (103).

12. A vacuum processing apparatus (200) for processing a flexible substrate (10), comprising:
a processing chamber (220) comprising a plurality of processing units (221) comprising at least one deposition unit; and
- a roller (100) according to any of claims 1 to 11 for guiding the flexible substrate past the plurality of processing units (221), including the roller (100) being connected to an electrical potential application device (140).

13. A method (300) of manufacturing a roller (100) for guiding a flexible substrate, the method being **characterized by** comprising:
producing (310) a sleeve (104) having a plurality of gas outlets (105) by using laser drilling, the sleeve comprising at least one of a metal layer (106) embedded within isolating material and a plurality of insets (130) of isolating material; and
providing (320) the sleeve (104) circumferentially around and in contact with a main body (101) of the roller (100) having a plurality of gas supply slits (103) provided in an outer surface of the main body (101) such that the plurality of gas outlets (105) is arranged above the plurality of gas supply slits (103).

14. The method of claim 13, further comprising providing (330) surfaces of the gas supply slits (103) with a coating of isolating material.

15. A method (400) of processing a flexible substrate, comprising:
guiding (410) the flexible substrate past one or more processing units (221) by using a roller (100) for transporting the flexible substrate (10) according to any of claims 1 to 11; and
controlling (420) a temperature of the flexible substrate (10) by providing gas to the flexible substrate through the plurality of gas outlets (105) of the roller (100), particularly further comprising applying an electrical potential to the metal layer (106) embedded within isolating material of the sleeve (104).

## Patentansprüche

1. Walze (100) zum Transportieren eines flexiblen Substrats (10), umfassend:
einen Hauptkörper (101) mit einer Vielzahl von Gaszufuhrschlitzen (103), die in einer Außenfläche (102) des Hauptkörpers (101) vorgesehen sind, wobei sich die Vielzahl von Gaszufuhrschlitzen (103) in Richtung einer zentralen Drehachse (111) der Walze (100) erstreckt; und
eine Hülse (104), die in Umfangsrichtung um den Hauptkörper (101) herum angeordnet ist und mit diesem in Kontakt steht, wobei die Hülse (104) eine Vielzahl von Gasauslässen (105) aufweist, die oberhalb der Vielzahl von Gaszufuhrschlitzen (103) angeordnet sind, wobei die Walze **dadurch gekennzeichnet ist, dass**
die Hülse (104) eine in Isoliermaterial eingebettete Metallschicht (106) umfasst.

2. Walze (100) nach Anspruch 1, wobei die Hülse (104) eine isolierende Deckschicht (107) und eine innere Isolierhülse (104I) umfasst, und die Metallschicht (106) zwischen der isolierenden Deckschicht (107) und der inneren Isolierhülse (104I) vorgesehen ist.

3. Walze (100) nach Anspruch 2, wobei die Metallschicht (106) unter der isolierenden Deckschicht (107), insbesondere direkt unter der isolierenden Deckschicht (107), vorgesehen ist.

4. Walze (100) nach Anspruch 2 oder 3, wobei die Metallschicht (106) auf der inneren Isolierhülse (104I) vorgesehen ist, insbesondere direkt auf der inneren Isolierhülse (104I).

5. Walze (100) nach einem der Ansprüche 2 bis 4, wobei sich die Vielzahl von Gasauslässen (105) durch die isolierende Deckschicht (107) und die innere Isolierhülse (104I) erstreckt, so dass Innenwände der Gasauslässe aus Isoliermaterial vorgesehen sind.

6. Walze (100) nach Anspruch 1, wobei die Hülse (104) eine äußere Isolierschicht (108) umfasst, die auf einer inneren Metallhülse (104M) vorgesehen ist, wobei die Metallschicht (106) in die äußere Isolierschicht (108) eingebettet ist, insbesondere wobei sich die Vielzahl von Gasauslässen (105) durch die äußere Isolierschicht (108) und die innere Metallhülse (104M) erstreckt, so dass Innenwände der Gasauslässe aus Material der äußeren Isolierschicht (108) und Material der inneren Metallhülse (104M) vorgesehen sind.

7. Walze nach einem der Ansprüche 1 bis 6, wobei die Metallschicht (106) mit einer Vorrichtung (140) zum Anlegen eines elektrischen Potentials verbunden ist.

8. Walze (100) zum Transportieren eines flexiblen Substrats (10), umfassend:
einen Hauptkörper (101) mit einer Vielzahl von Gaszufuhrschlitzen (103), die in einer Außenfläche (102) des Hauptkörpers (101) vorgesehen sind, wobei sich die Vielzahl von Gaszufuhrschlitzen (103) in Richtung einer zentralen Drehachse (111) der Walze (100) erstreckt; und
eine Hülse (104), die in Umfangsrichtung um den Hauptkörper (101) herum angeordnet ist und mit diesem in Kontakt steht, wobei die Walze **dadurch gekennzeichnet ist, dass** die Hülse (104) eine Vielzahl von Einsätzen (130) aus Isoliermaterial aufweist, wobei eine Vielzahl von Gasauslässen (105) oberhalb der Vielzahl von Gaszufuhrschlitzen (103) vorgesehen ist.

9. Walze (100) nach Anspruch 8, wobei die Oberflächen der Gaszufuhrschlitze (103) mit Isoliermaterial beschichtet sind.

10. Walze (100) nach Anspruch 8 oder 9, wobei die Hülse (104) eine isolierende Deckschicht (107) und eine innere Metallhülse (104M) umfasst.

11. Walze (100) nach einem der Ansprüche 1 bis 10, wobei die Anzahl der Gasauslässe (105) in Umfangsrichtung mit der Anzahl der Gaszufuhrschlitze (103) korrespondiert.

12. Vakuumprozessvorrichtung (200) zum Prozessieren eines flexiblen Substrats (10), umfassend:
eine Prozesskammer (220) mit einer Vielzahl von Prozesseinheiten (221), die mindestens eine Abscheideeinheit umfassen; und
- eine Walze (100) gemäß einem der Ansprüche 1 bis 11 zum Führen des flexiblen Substrats an der Vielzahl von Prozesseinheiten (221) vorbei, wobei die Walze (100) mit einer Vorrichtung (140) zum Anlegen eines elektrischen Potentials verbunden ist.

13. Verfahren (300) zur Herstellung einer Walze (100) zum Führen eines flexiblen Substrats, wobei das Verfahren **dadurch gekennzeichnet ist, dass** es umfasst:
Herstellen (310) einer Hülse (104) mit einer Vielzahl von Gasauslässen (105) mittels Laserbohren, wobei die Hülse mindestens eines von Folgenden umfasst: eine in Isoliermaterial eingebettete Metallschicht (106) oder eine Vielzahl von Einsätzen (130) aus Isoliermaterial; und
Vorsehen (320) der Hülse (104) in Umfangsrichtung um einen Hauptkörper (101) der Walze (100) herum und in Kontakt mit diesem, wobei der Hauptkörper (101) eine Vielzahl von Gaszufuhrschlitzen (103) aufweist, die in einer Außenfläche des Hauptkörpers (101) vorgesehen sind, derart, dass die Vielzahl von Gasauslässen (105) über der Vielzahl von Gaszufuhrschlitzen (103) angeordnet ist.

14. Verfahren nach Anspruch 13, ferner umfassend das Versehen (330) der Oberflächen der Gaszufuhrschlitze (103) mit einer Beschichtung aus Isoliermaterial.

15. Verfahren (400) zum Prozessieren eines flexiblen Substrats, umfassend:
Führen (410) des flexiblen Substrats an einer oder mehreren Prozesseinheiten (221) vorbei unter Verwendung einer Walze (100) zum Transportieren des flexiblen Substrats (10) gemäß einem der Ansprüche 1 bis 11; und
Regeln (420) einer Temperatur des flexiblen Substrats (10) durch Zuführen von Gas zu dem flexiblen Substrat durch die Vielzahl von Gasauslässen (105) der Walze (100), insbesondere ferner umfassend das Anlegen eines elektrischen Potentials an die Metallschicht (106), die in das Isoliermaterial der Hülse (104) eingebettet ist.

## Revendications

1. Rouleau (100) pour transporter un substrat flexible (10), comprenant :
un corps principal (101) comportant une pluralité de fentes d'alimentation en gaz (103) ménagées dans une surface extérieure (102) du corps principal (101), les fentes de la pluralité de fentes d'alimentation en gaz (103) s'étendant dans une direction d'un axe de rotation central (111) du rouleau (100) ; et
un manchon (104) disposé circonférentiellement autour du corps principal (101) et en contact avec ce dernier, le manchon (104) comportant une pluralité de sorties de gaz (105) qui sont disposées au-dessus des fentes de la pluralité de fentes d'alimentation en gaz (103), le rouleau étant **caractérisé en ce que** le manchon (104) comprend une couche métallique (106) incorporée dans un matériau isolant.

2. Rouleau (100) selon la revendication 1, dans lequel le manchon (104) comprend une couche supérieure isolante (107) et un manchon isolant intérieur (104I), et la couche métallique (106) est disposée entre la couche supérieure isolante (107) et le manchon isolant intérieur (104I).

3. Rouleau (100) selon la revendication 2, dans lequel la couche métallique (106) est disposée sous la couche supérieure isolante (107), particulièrement directement sous la couche supérieure isolante (107).

4. Rouleau (100) selon la revendication 2 ou la revendication 3, dans lequel la couche métallique (106) est disposée sur le manchon isolant intérieur (104I), particulièrement directement sur le manchon isolant intérieur (104I).

5. Rouleau (100) selon l'une quelconque des revendications 2 à 4, dans lequel les sorties de la pluralité de sorties de gaz (105) s'étendent à travers la couche supérieure isolante (107) et à travers le manchon isolant intérieur (104I), de façon à doter les parois intérieures des sorties de gaz d'un matériau isolant.

6. Rouleau (100) selon la revendication 1, dans lequel le manchon (104) comprend une couche isolante extérieure (108) disposée sur un manchon métallique intérieur (104M), la couche métallique (106) étant incorporée dans la couche isolante extérieure (108), particulièrement dans lequel les sorties de la pluralité de sorties de gaz (105) s'étendent à travers la couche isolante extérieure (108) et à travers le manchon métallique intérieur (104M), de façon à doter les parois intérieures des sorties de gaz d'un matériau de la couche isolante extérieure (108) et d'un matériau du manchon métallique intérieur (104M).

7. Rouleau selon l'une quelconque des revendications 1 à 6, dans lequel la couche métallique (106) est connectée à un dispositif d'application de potentiel électrique (140).

8. Rouleau (100) pour transporter un substrat flexible (10), comprenant :
un corps principal (101) comportant une pluralité de fentes d'alimentation en gaz (103) ménagées dans une surface extérieure (102) du corps principal (101), les fentes de la pluralité de fentes d'alimentation en gaz (103) s'étendant dans une direction d'un axe de rotation central (111) du rouleau (100) ; et
un manchon (104) disposé circonférentiellement autour du corps principal (101) et en contact avec ce dernier, le rouleau étant **caractérisé en ce que** le manchon (104) comporte une pluralité d'inserts (130) en matériau isolant, les sorties d'une pluralité de sorties de gaz (105) étant disposées au-dessus des fentes de la pluralité de fentes d'alimentation en gaz (103).

9. Rouleau (100) selon la revendication 8, dans lequel les surfaces des fentes d'alimentation en gaz (103) sont revêtues d'un matériau isolant.

10. Rouleau (100) selon la revendication 8 ou la revendication 9, dans lequel le manchon (104) comprend une couche supérieure isolante (107) et un manchon métallique intérieur (104M).

11. Rouleau (100) selon l'une quelconque des revendications 1 à 10, dans lequel le nombre de sorties de gaz (105) dans la direction circonférentielle correspond au nombre de fentes d'alimentation en gaz (103).

12. Appareil de traitement sous vide (200) destiné à traiter un substrat flexible (10), comprenant :
une chambre de traitement (220) comprenant une pluralité d'unités de traitement (221) comprenant au moins une unité de dépôt ; et
- un rouleau (100) selon l'une quelconque des revendications 1 à 11, destiné à guider le substrat flexible devant les unités de la pluralité d'unités de traitement (221), comprenant le rouleau (100) qui est connecté à un dispositif d'application de potentiel électrique (140).

13. Procédé (300) de fabrication d'un rouleau (100) destiné à guider un substrat flexible, le procédé étant **caractérisé en ce qu'**il comprend les étapes consistant à :
produire (310) un manchon (104) comportant une pluralité de sorties de gaz (105) au moyen d'un perçage par laser, le manchon comprenant au moins l'une d'une couche métallique (106) incorporée dans un matériau isolant et d'une pluralité d'inserts (130) en matériau isolant ; et
disposer (320) le manchon (104) circonférentiellement autour d'un corps principal (101), et en contact avec ce dernier, du rouleau (100) comportant une pluralité de fentes d'alimentation en gaz (103) ménagées dans une surface extérieure du corps principal (101) de sorte que les sorties de la pluralité de sorties de gaz (105) sont disposées au-dessus des fentes de la pluralité de fentes d'alimentation en gaz (103).

14. Procédé selon la revendication 13, comprenant en outre l'étape consistant à doter (330) les surfaces des fentes d'alimentation en gaz (103) d'un revêtement en matériau isolant.

15. Procédé (400) de traitement d'un substrat flexible, comprenant les étapes consistant à :
guider (410) le substrat flexible devant une ou plusieurs unités de traitement (221) en utilisant un rouleau (100) pour transporter le substrat flexible (10) selon l'une quelconque des revendications 1 à 11 ; et
réguler (420) une température du substrat flexible (10) en fournissant du gaz au substrat flexible à travers les sorties de la pluralité de sorties de gaz (105) du rouleau (100), particulièrement comprenant en outre l'étape consistant à appliquer un potentiel électrique à la couche métallique (106) incorporée dans un matériau isolant du manchon (104).
